Europäisches Patentamt

(19) · European Patent Office

Office européen des brevets

(11) Numéro de publication: **0 022 404**
**B1**

## FASCICULE DE BREVET EUROPEEN

(45) Date de publication du fascicule du brevet:
**16.03.83**

(51) Int. Cl.³: **H 03 B 5/18,** H 05 H 1/46

(21) Numéro de dépôt: **80400993.4**

(22) Date de dépôt: **01.07.80**

(54) **Générateur de plasma.**

(30) Priorité: **04.07.79 FR 7917359**

(43) Date de publication de la demande:
**14.01.81 Bulletin 81/2**

(45) Mention de la délivrance du brevet:
**16.03.83 Bulletin 83/11**

(84) Etats contractants désignés:
**AT BE CH DE GB IT LI LU NL SE**

(56) Documents cités:

**US-A-3 440 387**

**ANALYTICA CHIMICA ACTA, no. 84,
1976 AMSTERDAM, (NL)**
**M.H. ADBALLAH et al.: «Etude spectrométrique d'un plasma induit par haute fréquence. Partie I: Performances analytiques», pages 271-282**

(73) Titulaire: **INSTRUMENTS S.A., 8 rue de la Rochefoucauld, F-75009 Paris (FR)**
Titulaire: **Durr, René, 4-8 rue Jacques Porraz, F-73200 Albertville (FR)**

(72) Inventeur: **Durr, René, 4-8 rue Jacques Porraz, F-73200 Albertville (FR)**

(74) Mandataire: **Dupuy, Louis et al, CREUSOT-LOIRE 15 rue Pasquier, F-75383 Paris Cedex 8 (FR)**

ACTORUM AG

Générateur de plasma

La présente invention concerne un générateur de plasma plus particulièrement destiné, pour des analyses en spectrométrie d'émission, à la production d'une flamme de plasma à partir d'un jet gazeux, flamme dans laquelle sera introduit un aérosol de la solution à analyser.

On sait obtenir une flamme de plasma en faisant arriver un jet de gaz comme de l'argon à l'intérieur d'une bobine inductrice alimentée à très haute fréquence, de l'ordre par exemple de 40 à 60 MHz. Le générateur haute fréquence est donc un élément fondamental d'un appareil d'analyse en spectrométrie d'emission à plasma inductif.

Un tel générateur HF doit pouvoir être accordé sur une impédance très élevée pendant la courte période entre la mise en route et l'allumage de la flamme, puis s'adapter automatiquement à une impédance faible dès l'allumage, et donc présenter un très haut coefficient de surtension.

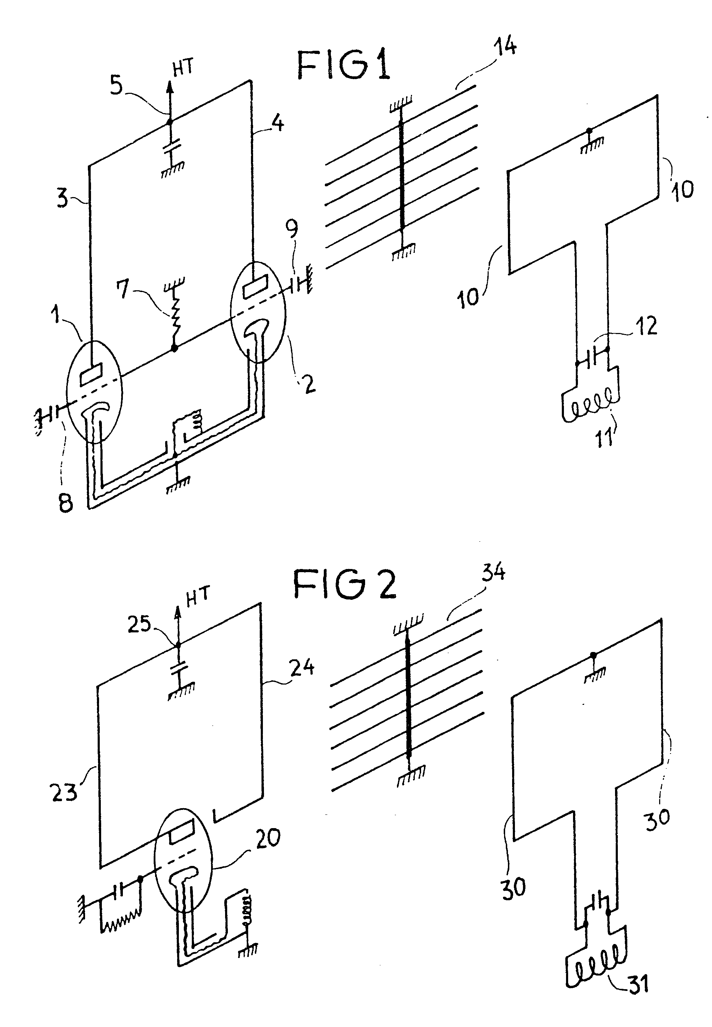

On a réalisé de tels générateurs HF dont l'oscillateur est du type à lignes accordées et destinés à la formation de plasma, ou autres applications nécessitant l'utilisation de fréquences élevées. Selon cette technique schématisée par la figure 1, on utilise deux triodes identiques 1 et 2 dont les lignes anodiques en quart d'onde 3 et 4 sont reliées en 5 où est appliquée la haute tension, de l'ordre par exemple de 3000 à 5000 volts. Les lignes cathodiques des deux tubes sont également couplées, de même que les grilles munies d'une résistance 7 et de capacités de découplage 8 et 9. Les lignes 10 de couplage de l'inducteur 11 sont reliées par une capacité 12. Pour supprimer la composante statique du couplage et ne capter que la composante magnétique, on dispose entre la boucle des lignes anodiques 3 et 4 et la boucle des lignes de couplage 10, un écran 14 formé par une série de dipoles ouverts. On pourra trouver une étude plus complète d'un tel générateur dans un article publié en 1976, pages 271 à 282 dans le numéro 84 de la revue «Analytica Chimica Acta».

Un tel générateur haute fréquence fonctionne tout à fait correctement tant que les tubes 1 et 2 sont de caractéristiques identiques, ce qui peut être obtenu avec des tubes neufs et apairés, ou à condition qu'ils vieillissent tous les deux de façon tout à fait parallèles. En pratique il en est rarement ainsi, et l'évolution différente du vieillissement de chacun des deux tubes conduit à un déséquilibre des circuits, par déplacement du point zéro de la haute fréquence, ce qui entraîne de graves perturbations de fonctionnement du générateur. En outre l'encombrement des deux tubes et de leurs alimentations et organes annexes devient vite excessif lorsque l'on met en jeu des puissances importantes.

La présente invention permet de garder les avantages d'un générateur à lignes accordées en quart d'onde, en éliminant les inconvénients du vieillissement aléatoire des tubes oscillateurs. Elle permet aussi la réalisation d'un générateur HF moins encombrant et moins onéreux.

L'invention s'applique donc à un générateur de plasma, constitué d'une tête d'amenée de gaz à ioniser dans une bobine inductrice, et un générateur inductif à haute fréquence comportant un circuit oscillateur à tube du type à lignes anodiques accordées en quart d'onde et un circuit de couplage relié à la bobine inductrice; selon l'invention le circuit anodique quart d'onde est commandé à partir d'un seul tube oscillateur, l'une des extrémités du circuit à partir du point zéro de la haute fréquence étant reliée à l'anode de ce tube, l'autre étant couplée extérieurement à cette même anode, par couplage capacitif.

Pour illustrer l'invention, on pourra se reporter à la figure 2 annexée qui représente, à titre d'exemple, et dans les mêmes conditions que la figure 1, le schéma d'un générateur HF réalisé selon l'invention.

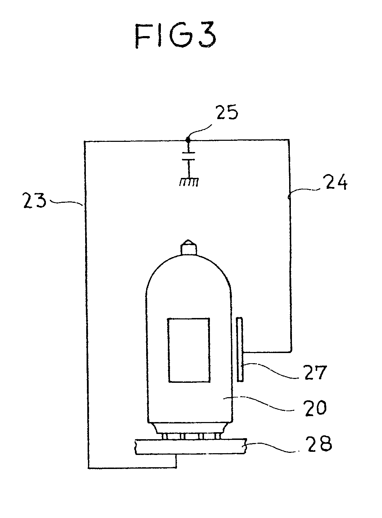

La figure 3 montre un exemple de couplage capacitif à l'anode.

A la figure 2, les lignes en quart d'onde 23 et 24, reliées en 25 à la haute tension, sont associées à une seule triode 20 dont l'alimentation cathodique est conforme à celle du dispositif à deux triodes. La ligne 23 est liée de façon connue à l'anode du tube 20. L'autre ligne 24 est couplée à cette même anode par un couplage capacitif. La figure 3 montre un exemple d'un tel couplage capacitif, où la ligne 24 est reliée à une plaque conductrice 27 extérieure au tube, et c'est l'enveloppe de verre du tube oscillateur 20 qui sert de diélectrique. La ligne 23 est normalement connectée, à travers le support 28, à la broche reliée à l'anode du tube.

La boucle des lignes de couplage 30 pour l'inducteur 31 est réalisée de façon équivalente à celle de la figure 1, et l'on pourra de même utiliser un écran 34 pour éliminer la composante statique, et rétablir la parfaite symétrie dans la boucle 30.

On a ainsi réalisé un générateur HF à lignes accordées présentant exactement les mêmes caractéristiques que celui de la figure 1, mais en utilisant un seul tube oscillateur. Il en résulte bien entendu une réduction d'encombrement, de poids et de coût de l'appareillage, mais on obtient surtout une permanence et une stabilité dans le temps des caractéristiques du générateur, puisque, une fois accordés, les circuits ne peuvent plus se déséquilibrer par suite du vieillissement du tube oscillateur.

**Revendications**

1. Générateur de plasma constitué d'une tête d'amenée de gaz à ioniser dans une bobine inductrice (31), et d'un générateur inductif à haute fréquence comportant un circuit oscillateur à tube du type à lignes anodiques accordées en quart d'onde et un circuit de couplage (30) relié à la bobine inductrice (31), caractérisé par le fait que le circuit anodique quart d'onde (23, 24) est commandé à partir d'un seul tube oscillateur (20), l'une des extrémités du circuit à partir du point (25) zéro de la haute fréquence étant reliée à l'anode de ce tube, l'autre étant couplé extérieurement à cette même anode par couplage capacitif.

2. Générateur de plasma selon revendication 1, caractérisé par le fait que le couplage capacitif est réalisé au moyen d'une plaque conductrice (27) extérieure au tube oscillateur, l'enveloppe de verre du tube (20) étant utilisée comme diélectrique.

3. Générateur de plasma selon l'une quelconque des revendications précédentes, caractérisé par le fait qu'il comporte, entre le circuit anodique (23, 24) et le circuit de couplage (30), un écran (34) formé d'une série de dipoles ouverts.

### Patentansprüche

1. Plasmagenerator, der aus einem Zufuhrkopf für in einer Induktionsspule (31) zu ionisierendes Gas und einem Hochfrequenz-Induktionsgenerator besteht, der einen Röhrenresonanz- bzw. -schwingkreis mit auf Viertelwellen abgestimmten Anodenleitungen und einen Kopplungsschaltkreis (30) umfasst, welcher mit der Induktionsspule (31) verbunden ist, dadurch gekennzeichnet, dass der anodische Viertelwellenschaltkreis (23, 24) ausgehend von einer einzigen Oszillatorröhre (20) gesteuert ist, wobei eines der Enden des Schaltkreises ausgehend vom Nullpunkt (25) der Hochfrequenz mit der Anode dieser Röhre verbunden ist, während das andere Ende von aussen her mit derselben Anode durch kapazitive Kopplung verbunden ist.

2. Plasmagenerator nach Anspruch 1, dadurch gekennzeichnet, dass die kapazitive Kopplung von einer ausserhalb der Oszillatorröhre angeordneten Leitplatte (27) gebildet ist, wobei die Glashülle der Röhre (20) als Dielektrikum vorgesehen ist.

3. Plasmagenerator nach einem der vorhergehenden Ansprüche, dadurch gekennzeichnet, dass zwischen dem anodischen Schaltkreis (23, 24) und dem Kopplungsschaltkreis (30) eine Abschirmung (34) vorgesehen ist, die von einer Reihe von offenen Dipolen gebildet ist.

### Claims

1. Plasma generator consisting of a head for introducing gas to be ionised into an induction coil (31), and of a high-frequency inductive generator comprising a tube oscillator circuit of the type with quarter-wave tuned anode lines, and a coupling circuit (30) connected to the induction coil (31), characterised in that the quarter-wave anode circuit (23, 24) is controlled from a single oscillator tube (20), one of the ends of the circuit, starting from the zero point (25) of the high frequency, being connected to the anode of this tube, and the other being coupled externally to this same anode by capacitive coupling.

2. Plasma generator according to claim 1, characterised in that the capacitive coupling is produced by means of a conducting plate (27) outside the oscillator tube, the glass envelope of the tube (20) being used as the dielectric.

3. Plasma generator according to either one of the preceding claims, characterised in that it comprises, between the anode circuit (23, 24) and the coupling circuit (30) a screen (34) formed of a series of open dipoles.

# FIG 1

# FIG 2

# FIG3